(19) Europäisches Patentamt
European Patent Office
Office européen des brevets

(11) **EP 0 639 892 B1**

(12) **EUROPÄISCHE PATENTSCHRIFT**

(45) Veröffentlichungstag und Bekanntmachung des Hinweises auf die Patenterteilung:
**08.07.1998   Patentblatt 1998/28**

(51) Int Cl.6: **H03H 21/00**

(21) Anmeldenummer: **94202339.1**

(22) Anmeldetag: **17.08.1994**

(54) **Digitale Filteranordnung**

Digital filter device

Dispositif de filtrage numérique

(84) Benannte Vertragsstaaten:
**CH DE FR GB IT LI**

(30) Priorität: **21.08.1993   DE 4328139**

(43) Veröffentlichungstag der Anmeldung:
**22.02.1995   Patentblatt 1995/08**

(73) Patentinhaber:
• **Philips Patentverwaltung GmbH**
  **22335 Hamburg (DE)**
  Benannte Vertragsstaaten:
  **DE**
• **PHILIPS ELECTRONICS N.V.**
  **5621 BA Eindhoven (NL)**
  Benannte Vertragsstaaten:
  **CH FR GB IT LI**

(72) Erfinder: **Frenzel, Rudi,**
**c/o Philips Patentverwaltung GmbH**
**D-20097 Hamburg (DE)**

(74) Vertreter: **Poddig, Dieter, Dipl.-Ing. et al**
**Philips Patentverwaltung GmbH,**
**Röntgenstrasse 24**
**22335 Hamburg (DE)**

(56) Entgegenhaltungen:
**EP-A- 0 301 627**

• **INT. CONF. ON ACOUST., SPEECH , AND SIGNAL PROC. 23-26 MAY 1989, GLASGOW, GB; MIN XU et al: TIME- FREQUENCY DOMAIN ADAPTIVE FILTERS, P 1154-1157.**

**Beschreibung**

Die Erfindung betrifft eine digitale Filteranordnung zum Erzeugen einer Folge von digitalen Filtersignalen aus einer Folge von einem Filtereingang zugeführten digitalen Eingangssignalen mit Hilfe einer Anzahl N Filterkoeffizienten.

Derartige Filter können als Zeitbereichsfilter oder als Frequenzbereichsfilter realisiert sein. Bei diesen verschiedenen Realisierungen können Probleme auftreten, die nachfolgend am Beispiel einer Anordnung zur Echoauslöschung für eine Telefon-Freisprechanlage näher erläutert werden sollen. Eine solche Anordnung enthält einen Empfangspfad für Empfangssignale, einen Signalanschluß zum Empfang eines durch Überlagerung eines örtlich erzeugten Signals und eines veränderten Empfangssignals gebildeten Eingangssignals, ein erstes digitales Filter der Ordnung N zur Erzeugung von Korrektursignalen aus Empfangssignalen, eine Überlagerungsanordnung zum Empfang des Eingangssignals und der Korrektursignale und zum Abgeben eines Sendesignals und eine Rechenanordnung mit einem ersten Frequenzbereichsfilter zur wiederholten adaptiven Erzeugung von Koeffizienten für das erste digitale Filter aus einem dem Sendesignal entsprechenden Hilfssignal, und ist bekannt aus der EP 0 301 627 A1.

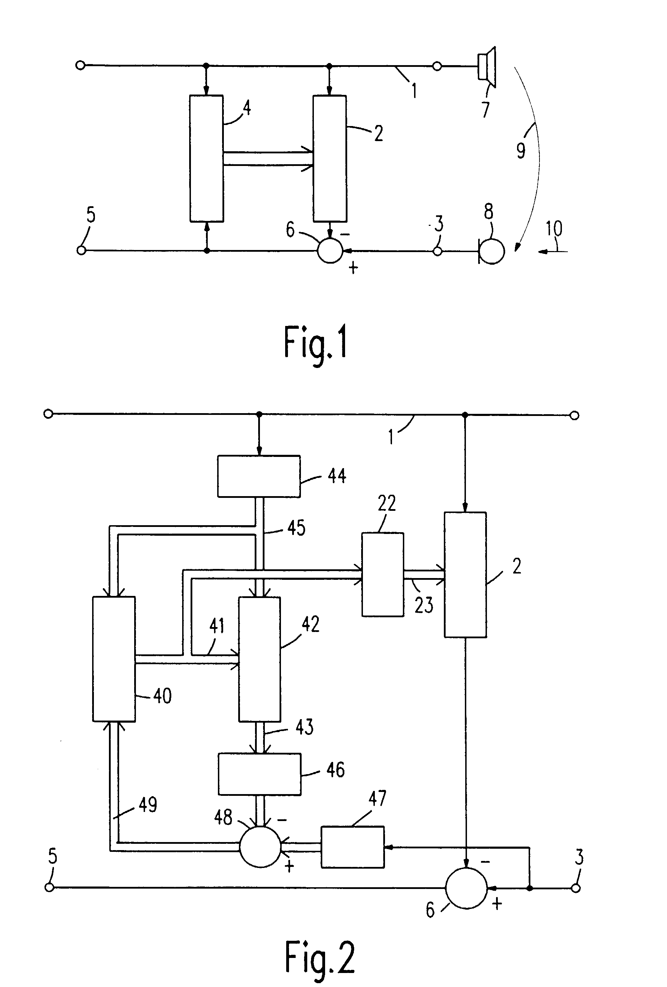

Der grundsätzliche Aufbau für die Anwendung in einer Freisprechanlage ist in Fig. 1 dargestellt. Über einen Empfangspfad 1 werden die Signale, allgemein Sprachsignale, von der Gegenstation empfangen und über einen Lautsprecher 7 wiedergegeben. Ein Mikrofon 8 nimmt das wiedergegebene Empfangssignal über einen Echopfad 9 zusammen mit einem örtlichen Signal 10, insbesondere von einem Sprecher zusammen auf. Der Echopfad 9 kann bei den typischen Umgebungsbedingungen in Freisprechanlagen in sehr guter Näherung als ein lineares dynamisches Übertragungssystem (Filter) modelliert werden, und er verändert das wiedergegebene Empfangssignal sowohl im Frequenzgang als auch in der zeitlichen Lage, d.h. es wird verzögert, und allgemein treffen mehrere verschieden verzögerte Empfangssignale mit verschieden veränderten Frequenzspektren überlagert beim Mikrofon 8 ein. Das von dem Mikrofon 8 erzeugte Eingangssignal wird einem Eingang 3 der Schaltungsanordnung zugeführt und über eine überlagerungsanordnung 6 an einen Sendeausgang 5 weitergeleitet, von wo es an die Gegenseite ausgesendet wird. Echoanteile im Sendesignal wirken auf die Gegenseite in der Regel störend. In Abhängigkeit von der Intensität der Echos und der Laufzeit zwischen den Endpunkten der Verbindung kann die Signalverständlichkeit erheblich beeinträchtigt werden. Weiterhin kann es insbesondere im Bereich von Zweidraht/VierdrahtÜbergängen im Telefonnetz dazu kommen, daß ein Teil des Sendesignals am Ausgang 5 auch dem Empfangspfad 1 zugeführt wird, so daß sich über den Echopfad 9 ein geschlossener Kreis ergibt, der zu Rückkopplungsschwingungen neigen kann. Es ist also erforderlich, aus dem Eingangssignal am Eingang 3 den über den Echopfad 9 kommenden Anteil möglichst weitgehend zu unterdrücken, bevor das Eingangssignal über den Ausgang 5 ausgesendet wird.

Dies geschieht mit Hilfe eines linearen, dynamischen Filters 2, das aus dem Empfangssignal auf dem Empfangspfad 1 ein Signal erzeugt, das weitgehend dem über den Echopfad 9 beim Mikrofon 8 eintreffenden Echosignal entspricht, und dieses Echosignal wird in der Überlagerungsanordnung 6 von dem Eingangssignal subtrahiert, so daß am Ausgang 5 im wesentlichen nur noch das Signal 10 des örtlichen Sprechers erscheint. Da die Eigenschaften des Echofads 9 jedoch weitgehend von den örtlichen Gegebenheiten abhängen und sich auch kurzzeitig stark ändern können, kann das Filter 2 nicht fest eingestellt sein, sondern dessen Koeffizienten müssen ständig an das momentane Echosignal angepaßt werden. Dies geschieht mit Hilfe einer Rechenanordnung 4 nach bekannten Algorithmen. Dabei arbeiten die Rechenanordnung 4 und auch das Filter 2 üblicherweise mit zeitdiskreten digitalen Signalwerten, während das Empfangssignal auf dem Empfangspfad 1 und das Eingangssignal am Eingang 3 üblicherweise analog sind. Die in diesem Falle notwendigen Analog-Digital-Wandler bzw. umgekehrten Wandler sind in Fig. 1 und auch in den folgenden Figuren nicht näher dargestellt.

Der in der Rechenanordnung 4 verwendete Algorithmus zur adaptiven Bestimmung der Filterkoeffizienten soll zum einen möglichst wenig Rechenaufwand erfordern und zum anderen möglichst schnell konvergieren. Einen günstigen Kompromiß zwischen den beiden, typischerweise nur schwer gleichzeitig erfüllbaren Forderungen bietet die Anwendung von Block-Frequenzbereichs-Algorithmen. Das bedeutet, daß auch die Koeffizienten des Filters 2 im Frequenzbereich erzeugt werden, so daß sich für dieses Filter ein Frequenzbereichsfilter anbietet. Dies hat jedoch den Nachteil, daß der serielle Datenstrom zwischen dem Eingang 3 und der Überlagerungsanordnung 6 zur Verarbeitung mit den Ausgabewerten des Frequenzbereichsfilters in Datenblöcke umzuformen ist. Die Blockbildung ist mit einer Signalverzögerung verbunden, die gleich dem Zeitraum für die Abtastung der nichtüberlappenden Signalwerte zweier aufeinanderfolgender Datenblöcke ist. Dieser Zusammenhang wird in der weiteren Beschreibung deutlicher. Eine derartige Verzögerung des Sendesignals ist jedoch insbesondere bei Freisprechanlagen nicht akzeptabel (siehe auch CCITT Recommendation G. 167).

In der vorgenannten EP 0 301 627 A1 wird daher für das Filter 2 ein Zeitbereichsfilter verwendet, das verzögerungsfrei arbeitet. Dieses Zeitbereichsfilter hat jedoch einen hohen Rechenbedarf, und außerdem ist zu berücksichtigen, daß das Zeitbereichsfilter das Frequenzbereichsfilter nur im Hinblick auf die Berechnung des ersten Korrektursignals ersetzt, während es innerhalb der Rechenanordnung 4 weiterhin zur Berechnung des Hilfssignals benötigt wird. Letzteres dient für die Berechnungen zur ständigen Adaption der Filterkoeffizienten. Wie anhand von Fig. 2, die einen in der genannten Druckschrift dargestellten Aufbau vereinfacht wiedergibt, deutlich wird, steigt der Aufwand für ein System mit zusätzlichem Zeitbereichsfilter im Vergleich zu einem reinen Block-Frequenzbereichsfilter im wesentlichen um den Aufwand für das zusätzliche Zeitbereichsfilter an.

In der Anordnung nach Fig. 2 wird in einer Transformationsanordnung 44 ein Block aufeinanderfolgender digitaler Empfangssignale in parallele Darstellung umgewandelt und einer blockweisen orthogonalen Transformation unterworfen, wofür zweckmäßig eine schnelle Fourier-Transformation (FFT) verwendet wird, um den Block aufeinanderfolgender Empfangssignale in den Frequenzbereich zu transformieren. Die Signalblöcke umfassen B Werte, wobei sich aufeinanderfolgende Blöcke mit mindestens N-1 Werten überlappen müssen. Die Anzahl L der neuen, nichtüberlappenden Werte pro Block bestimmt den Zeitraum, der zum Sammeln eines Blocks erforderlich ist. Block-Frequenzbereichsalgorithmen, die diesen Forderungen genügen, bezeichnet man als "Overlap-Save"-Verfahren. Aufwandsgünstige Realisierungen werden mit B=2N, L=N erzielt.

Die am Ausgang 45 auftretenden Signale im Frequenzbereich werden einer Rechenanordnung 40 und einem Frequenzbereichsfilter 42 zugeführt. Dieses erzeugt am Ausgang 43 einen Block gefilterter Signale im Frequenzbereich, die über eine weitere Transformationsanordnung 46 einer inversen orthogonalen Transformation, d.h. in diesem Falle einer inversen schnellen Fourier-Transformation (IFFT) unterworfen werden. Die Transformationsanordnung 46 gibt die in den Zeitbereich transformierten Signale blockweise an eine zweite Überlagerungsanordnung 48 ab, die an einem zweiten Eingang die Eingangssignale vom Eingang 3 empfängt, und zwar über eine Anordnung 47, die den seriellen Datenstrom der Eingangssignale des Eingangs 3 in eine parallele Darstellung, d.h. in Datenblöcke umwandelt. Dabei sind dieselben Regeln (Überlappung) wie bei der Blockbildung vor der Transformationseinrichtung einzuhalten. Die am Ausgang der Transformationsanordnung 46 auftretenden Signale, die also im adaptierten Fall den verzögerten Echosignalen des Echopfads entsprechen, werden von den Signalen am Ausgang der Anordnung 47 subtrahiert, so daß auf der Ausgangsleitung 49 der zweiten Überlagerungsanordnung 48 ein echounterdrücktes Signal entsteht, das dem Sendesignal am Ausgang 5 weitgehend entspricht, jedoch gegenüber diesem zeitlich verschoben ist. Dieses Hilfssignal auf der Leitung 49 wird der Rechenanordnung 40 zugeführt, um die Filterkoeffizienten auf der Verbindung 41 ständig zu adaptieren.

Diese Filterkoeffizienten werden außerdem einer Transformationsanordnung 22 zugeführt, in der diese Filterkoeffizienten mit Hilfe einer orthogonalen Transformation, die der in der Transformationsanordnung 46 entspricht, in Zeitbereichs-Koeffizienten umgesetzt werden, die über die Verbindung 23 dem Zeitbereichsfilter 2 zugeführt werden. Außerdem werden diese Koeffizienten auf der Verbindung 23 zwischengespeichert, wie in der vorgenannten Druckschrift beschrieben ist, was jedoch in diesem Zusammenhang nicht von Bedeutung ist. Die vom Filter 2 mit Hilfe dieser Koeffizienten verzögerungsfrei erzeugten gefilterten Signale werden der ersten überlagerungsanordnung 6 zugeführt und dort von den am Eingang 3 erhaltenen Eingangssignalen subtrahiert, um das Sendesignal zu erzeugen, das am Ausgang 5 abgegeben wird. Unter anwendungsorientierten Gesichtspunkten kann die Berechnung in der Transformationsanordnung 22 und die Bereitstellung der neu adaptierten Koeffizienten auf der Verbindung 23 verzögert werden, um eine günstige zeitliche Aufteilung der einzelnen Rechenschritte des Algorithmus zu erzielen.

Ein Zeitbereichsfilter erfordert, wie bereits angedeutet, einen hohen Rechenaufwand. Bei einem Filter der Ordnung N mit N Koeffizienten fallen für jedes Korrektursignal N Multiplikationen und N Additionen an. Damit sind beispielsweise bei 8 kHz Abtastfrequenz für die Digitalisierung und N=2048 Filterkoeffizienten etwa 16,4 Millionen Additionen und Multiplikationen pro Sekunde erforderlich. Dies ist mit einem üblichen Signalprozessor, wie er für die Realisierung eines Filters allgemein eingesetzt wird, praktisch kaum durchführbar, so daß mehrere Prozessoren hierfür eingesetzt werden müssen.

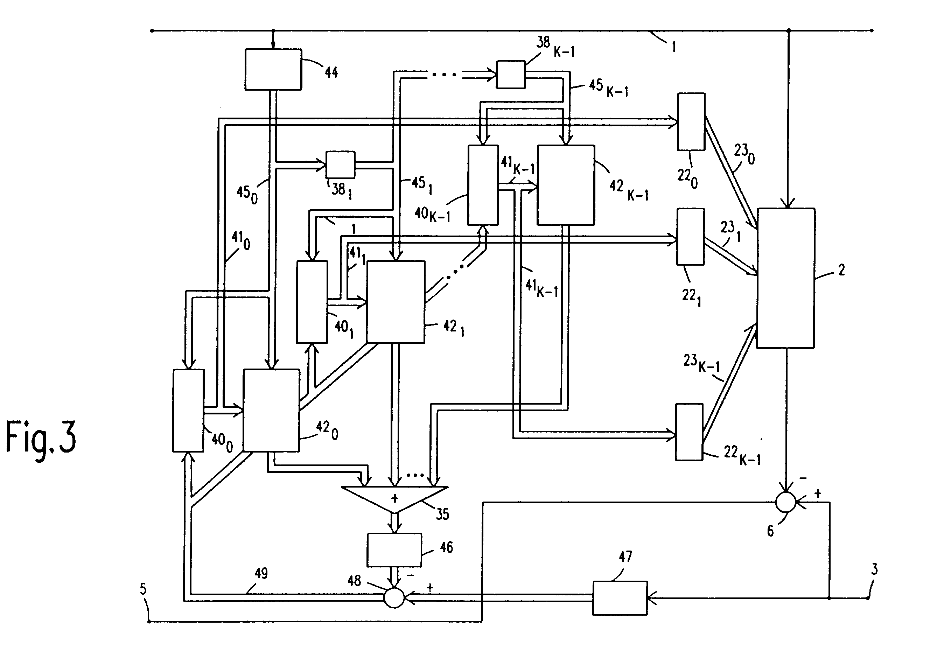

In der Zeitschrift "IEEE Trans. on ASSP", Vol. 38, No. 2, 1990, pp 373-376 ist unter dem Titel "Multi Delay Block Frequency Domain Adaptive Filter" ein partitioniertes Block-Frequenzbereichsfilter beschrieben, das für Echo-Auslöschungsanordnungen in Telefonanlagen verwendbar ist. Die Fig. 3 zeigt die Struktur des Verfahrens. Im Unterschied zu dem geschlossenen Frequenzbereichsalgorithmus werden bei dem partitionierten Verfahren die N Filterkoeffizienten w(i) nicht in einem Block, sondern in K Partitionen der Größe M=N/K bestimmt. Auf den Verbindungen $23_0$ bis $23_{K-1}$ liegen die Zeitbereichskoeffizienten w(O)...W(M-1), w(M)...w(2M-1) bis w(K-1)M...w(KM-1) vor. Mit dem Filter 2 wird durch die Faltungsoperation

$$\hat{y}(n)=\sum_{p=0}^{K-1}\sum_{i=0}^{M-1}x(n-pM-i)w(pM+i)=\sum_{i=0}^{N-1}x(n-i)w(i)$$

das erste Korrektursignal ŷ(n) bestimmt. Die Berechnung der Frequenzbereichskoeffizienten erfolgt partitionsweise in "Adaptionsanordnungen", die sich jeweils aus einer Rechenanordnung $40_0$ bis $40_{K-1}$ und einem Frequenzbereichsfilter

$42_0$ bis $42_{K-1}$ zusammensetzen. Diese werden eingangsseitig über die Verbindung $45_0$ bis $45_{K-1}$ mit Datenblöcken gespeist, die gegenüber dem geschlossenen Adaptionsverfahren um einen Faktor K kleiner sind. Die Eingangsdaten benachbarter Adaptionsanordnungen sind durch Verzögerungseinheiten 38 um jeweils eine Blockdauer gegeneinander verzögert. Diese entspricht einem Zeitraum von M Eingangssignalen. Die erste Adaptionsanordnung wird von einer Transformationsanordnung 44 gespeist, die eingangsseitig B = 2M Eingangssignale zu einen Eingangsdatenblock zusammenfaßt. Jeder Eingangsdatenblock überlappt sich mit dem vorhergehenden Block um M Eingangssignale. Die Ausgangssignale der K Frequenzbereichsfilterpartitionen $42_0$ bis $42_{K-1}$ werden in einer Summiereinheit 35 aufaddiert und einer Transformationseinheit 46 zugeführt. Am Ausgang dieser Transformationseinheit steht ein zweites Korrektursignal zur Verfügung, das im wesentlichen einer verzögerten Version des ersten Korrektursignals entspricht. Aus dem zweiten Korrektursignal und jeweils einer Anzahl M durch die Anordnung 47 zu einem Datenblock zusammengefaßter Eingangsdaten vom Eingang 3 wird in einer zweiten Überlagerungsanordnung 48 ein Hilfssignal zur Adaption der Frequenzbereichskoeffizienten berechnet und über die Verbindung 49 allen Rechenanordnungen $40_0$ bis $40_{K-1}$ zugeführt.

Aufgabe der Erfindung ist es, eine digitale Filteranordnung der eingangs genannten Art anzugeben, das ohne Totzeit, d.h. ohne Verzögerung arbeitet und weniger Aufwand erfordert und somit besonders günstig für Anordnungen zur Echoauslöschung geeignet ist.

Diese Aufgabe wird erfindungsgemäß dadurch gelöst, daß das Filter ein Zeitbereichsfilter der Ordnung M1 zum Erzeugen erster Teilfiltersignale unter Verwendung der ersten M1 Koeffizienten und ein Frequenzbereichsfilter der Ordnung M2 zum Erzeugen zweiter Teilfiltersignale unter Verwendung der folgenden M2 Koeffizienten umfaßt mit M1+M2=N, wobei die Summe des ersten und des zweiten Teilfiltersignals das Filtersignal darstellt.

Die Erfindung nutzt die Tatsache aus, daß jedes Filtersignal (n) im Zeitbereich aus einer linearen Kombination, nämlich aus einer Summe einzelner Anteile besteht, die aus dem momentanen und aus zurückliegenden Eingangssignalen gebildet werden. Diese Summe läßt sich nun wie folgt aufteilen:

$$\hat{y}(n) = \hat{y}_I(n) + \hat{y}_{II}(n) \tag{1}$$

mit

$$\hat{y}_I(n) = \sum_{i=0}^{M1-1} x(n-i)w(i) \tag{2}$$

und

$$\hat{y}_{II}(n) = \sum_{i=M1}^{N-1} x(n-i)w(i). \tag{3}$$

Der erste Anteil gemäß Gleichung (2) wird durch das Zeitbereichsfilter verzögerungsfrei bestimmt, wobei der Aufwand für das Zeitbereichsfilter, d.h. die Anzahl der Rechenschritte für ein Filtersignal, um den Faktor N/M1 kleiner ist, als wenn das gesamte Filter als Zeitbereichsfilter ausgeführt wäre. Wenn die Koeffizienten des gesamten Filters im Frequenzbereich vorliegen, brauchen auch nur die ersten M1 Koeffizienten, in den Zeitbereich transformiert zu werden, und zwar einmal für jeweils M1 Eingangssignale. Der zweite Anteil gemäß (3) kann dagegen in dem Frequenzbereichsfilter bestimmt werden, denn für diesen Anteil werden nur verzögerte Eingangssignale der Folge verwendet, die mindestens um M1 Eingangssignale verzögert sind.

Diese verzögerten Eingangssignale müssen für ein einfaches Frequenzbereichsfilter parallel vorliegen, so daß die Ordnung des Frequenzbereichsfilter kleiner sein muß als die Ordnung des Zeitbereichsfilter. Bei Filtern hoher Ordnung, wie sie beispielsweise bei der erwähnten Echoauslöschung benötigt werden, ergibt sich daraus bereits eine deutliche Einsparung von Rechenaufwand. Eine wesentliche Verbesserung wird jedoch erreicht, wenn das Frequenzbereichsfilter derart aufgebaut ist, daß die dafür benötigten Eingangssignale nur blockweise parallel vorliegen müssen. Dies ist der Fall, wenn nach einer Ausgestaltung der Erfindung das Frequenzbereichsfilter aus (K-p) Partitionen für die blockweise Verarbeitung von je M Signalen aufgebaut ist, mit M=N/K, K=2,3,4...und p=1,2,...<K, wobei M1=M·p und M2=M(K-p) ist. Dabei wird der vorher beschriebene bekannte Block-Frequenzbereichs-Algorithmus vorteilhaft ausgenutzt.

Die Möglichkeit, den zweiten Anteil mit einem Frequenzbereichsfilter zu bestimmen, ist dann gegeben, wenn p≥1, K>1 ist, wobei für p=1 zu berücksichtigen ist, daß dann während der Zeitspanne zwischen dem letzten Abtastsignal eines Blocks und dem ersten Eingangssignal des darauffolgenden Blocks die vollständige Verarbeitung dieses Blocks von Eingangssignalen im Frequenzbereichsfilter einschließlich der vorhergehenden und nachfolgenden Transformation durchgeführt werden müßte, während in der übrigen Zeit im Frequenzbereichsfilter keine Verarbeitungsvorgänge erfolgen würden.

Eine zweckmäßigere Ausgestaltung der Erfindung geht dagegen von dem Gedanken aus, daß für die Verarbeitungszeit eines Blocks von Eingangssignalen im Frequenzbereichsfilter eine Zeitspanne entsprechend einer Vielzahl von Eingangssignalen zur Verfügung stehen sollte, beispielsweise eine Zeitspanne entsprechend einem Block von Eingangssignalen, während parallel die Eingangssignale für den nächsten Block aufgenommen werden. Die Ordnung des Zeitbereichsfilters sollte möglichst klein sein, d.h. der Wert für M·p sollte klein sein, da das Zeitbereichsfilter besonders viele Rechenschritte erfordert. Andererseits steigt mit der Partitionsanzahl K (kleines M) das Verhältnis von Rechenaufwand zu der zur Verfügung stehenden Rechenzeit, so daß K nicht beliebig erhöht werden kann. Unter Berücksichtigung dieser Gesichtspunkte ist eine Ausgestaltung der Erfindung dadurch gekennzeichnet, daß K≥4 und p=2 ist. Durch die Wahl des Wertes von p=2 kann für das Frequenzbereichsfilter also ein Block von M neuen Eingangssignalen während der Zeitdauer dieses Blocks gesammelt und in Paralleldarstellung umgewandelt werden, und während der Zeitdauer des folgenden Blocks kann die Verarbeitung im zweiten Frequenzbereichsfilter erfolgen einschließlich der ausgangsseitigen Transformation vom Frequenzbereich in den Zeitbereich, und damit können die zweiten Teilfiltersignale mit einer Verzögerungszeit von 2·M Abtasttakten abgegeben werden. Damit ist die in der Gleichung (3) enthaltene Bedingung für die Verzögerungszeit erfüllt.

Die Erfindung betrifft ferner eine Schaltungsanordnung zur Echoauslöschung mit einem erfindungsgemäßen Filter, das zwischen einen Eingangspfad für Eingangssignale und einem Eingang einer Überlagerungsanordnung geschaltet ist, von der ein anderer Eingang zum Empfang eines durch Überlagerung eines örtlich erzeugten Signals eingerichtet ist, und mit einer Rechenanordnung sowie einem zweiten Filter zur wiederholten adaptiven Erzeugung von Koeffizienten für das erste Filter. Durch die Verwendung des erfindungsgemäßen Filters wird eine Schaltungsanordnung zur Echoauslöschung mit sehr günstigen Eigenschaften erhalten.

Zur adaptiven Erzeugung der Koeffizienten für die Filter benötigt die Rechenanordnung ein Hilfssignal, das durch Subtraktion eines zweiten Korrektursignals von dem verzögerten Eingangssignal gebildet wird.

Das zur Berechnung des Hilfssignals erforderliche zweite Korrektursignal wird, wie in Fig. 3 gezeigt, durch ein zweites Filter erzeugt. Wenn dieses zweite Filter ein weiteres Frequenzbereichsfilter ist und dieses weitere Frequenzbereichsfilter sowie das Frequenzbereichsfilter des ersten Filters aus Partitionen für die blockweise Verarbeitung von je M Signalen aufgebaut ist, ist es bei einer solchen Schaltungsanordnung besonders zweckmäßig, daß die erste Partition eine beiden Frequenzbereichsfiltern gemeinsame Transformationsanordnung zur Durchführung einer orthogonalen Transformation eines Blocks Eingangssignale und die folgenden Partitionen je eine beiden Frequenzbereichsfiltern gemeinsame Speicheranordnung zum Speichern eines von der Transformationsanordnung bzw. von der Speicheranordnung der vorhergehenden Partition abgegebenen Blocks transformierter Signale umfassen. Auf diese Weise sind für das erste Frequenzbereichsfilter keine gesonderten Speicheranordnungen und auch keine gesonderte eingangsseitige Transformationsanordnung erforderlich. Damit ergibt sich ein preisgünstiger Aufbau, da die in den Filtern und in der Rechenanordnung durchzuführenden Multiplikationen und Additionen ebenso wie die Transformationen allgemein mittels Signalprozessoren durchgeführt werden, so daß im wesentlichen nur noch zusätzlich Speicher erforderlich sind.

Ausführungsbeispiele der Erfindung werden nachstehend anhand der weiteren Figuren erläutert. Es zeigen:

Fig. 4 den grundsätzlichen Aufbau eines erfindungsgemäßen Filters,
Fig. 5 das Blockschaltbild einer Schaltungsanordnung zur Echoauslöschung mit einem erfindungsgemäßen Filter für p=2,
Fig. 6 schematisch den Aufbau der beiden Frequenzbereichsfilter in Fig. 5 mit gemeinsamen Elementen.

In diesen Figuren sind Elemente, die gleich aufgebaut sind bzw. die gleiche Funktion haben wie entsprechende Elemente in den Fig. 1 bis 3, mit den gleichen Bezugszeichen bezeichnet.

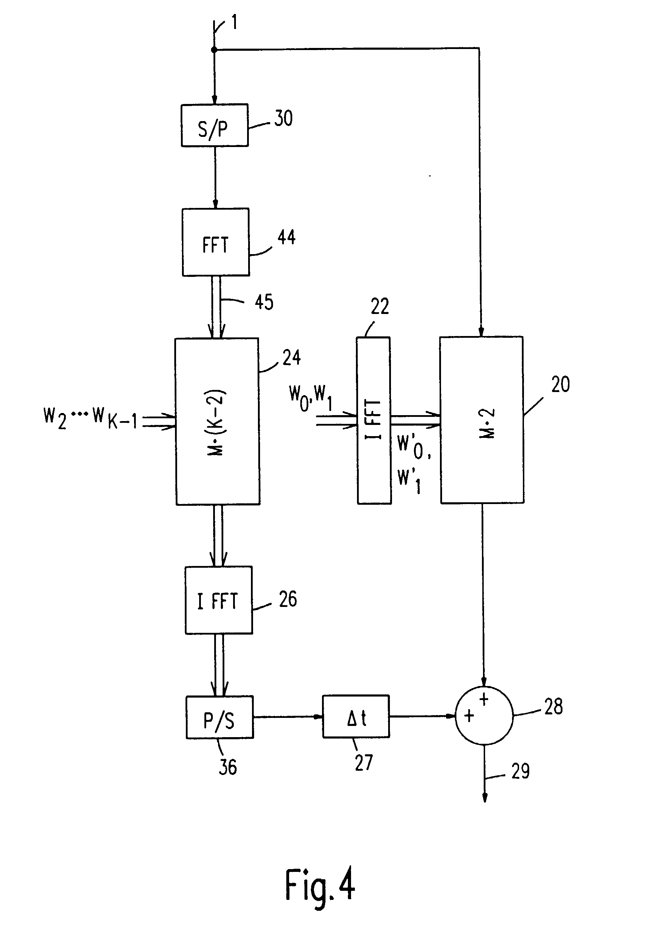

In Fig. 4 ist an einen Eingang 1 ein Serien-Parallel-Wandler 30 angeschlossen, der einen Block von 2M Empfangssignalen (M neue Werte sowie M überlappende Werte) in eine Paralleldarstellung umsetzt und einer Transformationsanordnung 44 zuführt, die diesen Block Eingangssignale mittels einer schnellen Fourier-Transformation FFT in den Frequenzbereich umsetzt. Die schnelle Fourier-Transformation ist hier nur als Beispiel zu verstehen, es kann auch eine andere bekannte orthogonale Transformation verwendet werden. Der am Ausgang 45 erzeugte Block von transformierten Daten wird einem Frequenzbereichsfilter 24 zugeführt. Der Übersichtlichkeit halber ist die Filteranordnung, die tatsächlich aus mehreren Partitionen entsprechend den Filtern $42_0$ bis $42_{K-1}$ in Fig. 3 besteht, vereinfacht nur als einzelne Einheit dargestellt.

Die Eingangssignale vom Eingang 1 werden außerdem einem Zeitbereichsfilter 20 zugeführt, das von den zugeführten Koeffizienten die ersten beiden Blöcke $W_0$ und $W_1$ von Koeffizienten, und zwar die von der Transformationsanordnung 22 in den Zeitbereich transformierten Blöcke $W'_0$, $W'_1$ von Koeffizienten erhält. Dieses Zeitbereichsfilter 20 erzeugt also einen unverzögerten Strom von ersten Teilfiltersignalen, die dem einen Eingang einer Summieranordnung 28 zugeführt werden.

Das Frequenzbereichsfilter 24 mit der Ordnung M(K-2) empfängt die Blöcke $W_2$ bis $W_{K-1}$ der Koeffizienten und gibt am Ausgang 25 zweite Teilfiltersignale im Frequenzbereich ab, die mittels der Transformationsanordnung 26 zur Durchführung einer inversen schnellen Fourier-Transformation in einen Block von zweiten Teilfiltersignalen im Zeitbereich umgesetzt und über den Parallel-Serien-Wandler 36 zeitlich nacheinander über eine Verzögerungseinheit 27, die eine Verzögerung entsprechend M Abtastintervallen bewirkt, an den zweiten Eingang der Summieranordnung 28 abgegeben werden. Diese erzeugt am Ausgang 29 eine Folge von Filtersignalen.

In dieser Anordnung erzeugt also das Zeitbereichsfilter 20 den in der eingangs genannten Gleichung (2) angegebenen Signalanteil, wenn p=2 gesetzt wird, während das Frequenzbereichsfilter 24 in Verbindung mit der Transformationseinheit 26 und der Verzögerungsanordnung 27 den Signalanteil gemäß Gleichung (3) erzeugt. Am Ausgang 29 der Summieranordnung 28 entsteht also das Gesamtsignal gemäß Gleichung (1).

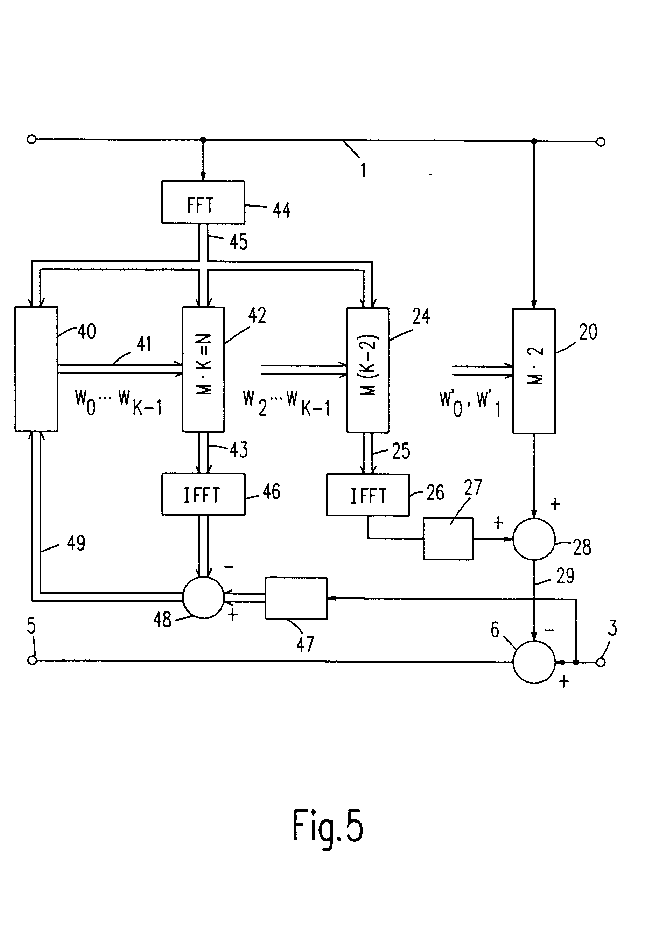

Eine Schaltungsanordnung zur Echoauslöschung, die den vorstehend beschriebenen Filteraufbau verwendet, ist in Fig. 5 dargestellt. Darin sind der Übersichtlichkeit halber Serien-Parallel-Wandler und Parallel-Serien-Wandler weggelassen. Doppelte Linien bezeichnen wieder Verbindungen, über die mehrere Werte bzw. Signale parallel übertragen werden.

In der Anordnung nach Fig. 5 werden am Ausgang 29 der Summieranordnung 28 erste Korrektursignale erzeugt, die denjenigen Signalen entsprechen sollen, die durch die akustische Verbindung zwischen dem Empfangspfad 1 und dem Eingang 3 erzeugt werden. Dieser Eingang 3 ist mit einem Eingang einer Subtrahieranordnung 6 verbunden, deren subtrahierender Eingang die Korrektursignale vom Ausgang 29 empfängt und die damit am Ausgang 5 auszusendende Sprachsignale abgibt, die von störenden Echos befreit sind. Dafür erhält das Frequenzbereisfilter 24 die Blöcke $W_2$ bis $W_{K-1}$ der Filterkoeffizienten, und das Zeitbereichsfilter 20 erhält die Blöcke $W'_0$ und $W'_1$ der Filterkoeffizienten, die in den Zeitbereich transformiert sind, wobei die entsprechende Transformationsanordnung hier der Übersichtlichkeit halber ebenfalls weggelassen ist.

Die Blöcke $W_0$ bis $W_{K-1}$ werden von einer Rechenanordnung 40 erzeugt, die ebenfalls an den Ausgang 45 der Transformationsanordnung 44 angeschlossen ist, und außerdem ist daran ein weiteres Frequenzbereichsfilter 42 mit der Ordnung $M \cdot K = N$ angeschlossen, das alle Blöcke $W_0$ bis $W_{K-1}$ über die Verbindung 41 von der Rechenanordnung 40 erhält. Dieses letztere Frequenzbereichsfilter 42 erzeugt am Ausgang 43, der in der Fig. 3 dem Ausgang der Summiereinheit 35 entspricht, einen Block von M zweiten Korrektursignalen, die einer inversen Fourier-Transformationsanordnung 46 zugeführt werden. Diese erzeugt daraus einen Block von transformierten zweiten Korrektursignalen im Zeitbereich und gibt diese zweiten Korrektursignale parallel an den Subtrahiereingang einer überlagerungsanordnung 48 ab. Diese empfängt am Addiereingang über eine Anordnung zur Bildung von parallelen Datenblöcken aus einem seriellen Datenstrom 47 das dem Eingang 3 zugeführte Eingangssignal und erzeugt auf der Leitung 49 ein Hilfssignal, das in der Rechenanordnung 40 zur adaptiven Erzeugung der Koeffizienten verwendet wird. Dies entspricht dem in Fig. 3 dargestellten Aufbau.

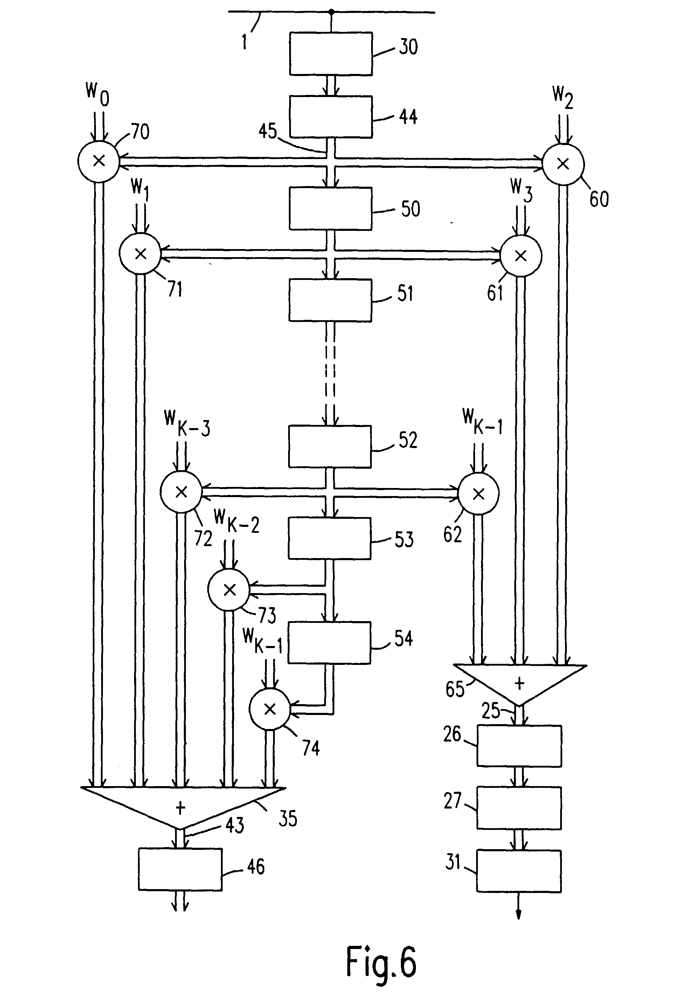

Die beiden Frequenzbereichsfilter 24 und 42 bestehen aus einer Anzahl Partitionen, wie dies in Fig. 6 angedeutet ist. In jeder Partition wird ein Block von Eingangsdaten verarbeitet, und zwar im wesentlichen durch Multiplikation mit einem zugehörigen Block von Koeffizienten und Summierung der Produkte. Die im Filter 24 durchzuführenden Multiplikationen sind in Fig. 6 symbolisch durch Multiplizierer 60, 61 und 62 angedeutet, während die Multiplikationen in den Filterpartitionen 42 durch die Multiplizierer 70 bis 74 angedeutet sind. Die Summierungen sind durch die Summierer 65 bzw. 35 angedeutet. Die Daten, die in jeder Partition verarbeitet werden, sind in Speichern 50 bis 54 enthalten. Diese Speicher sind beiden Filtern gemeinsam.

Die zu verarbeitenden Daten in jeder Partition werden durch einen Block Eingangsdaten gebildet, die in der Transformationsanordnung 44 aus dem Zeitbereich in den Frequenzbereich blockweise transformiert werden. Dazu müssen die Eingangsdaten parallel vorliegen, was mit der Anordnung 30 erreicht wird. Darin wird das auf dem Empfangspfad 1 vorhandene Empfangssignal periodisch abgetastet und in eine Folge von Digitalwerten umgewandelt, und es wird jeweils ein Block von digitalen Daten gesammelt und an die Transformationsanordnung 44 übertragen. Jeweils unmittelbar nach dem Ende eines Blocks von Eingangsdaten beginnt die Sammlung der Eingangsdaten des folgenden Blocks.

Während dieser Zeit wird der vorhergehende Block von Daten in der Transformationsanordnung 44 transformiert, und die vorher vorhandenen transformierten Daten werden in den Speicher 50 übertragen, dessen früheren Daten in den Speicher 51 usw., während die vorhergehenden Daten des Speichers 54 lediglich überschrieben und damit gelöscht werden.

Sobald die Transformationsanordnung 44 eine Transformation durchgeführt hat und die transformierten Daten am Ausgang 45 abgibt und die Daten aller Speicher 50 bis 54 um einen Speicher weitergeschoben worden sind, beginnt die Durchführung der Multiplikationen. Dabei werden die am Ausgang 45 er Transformationsanordnung 44 abgegebenen Daten für die Realisierung des Filters 24 in Fig. 3 in dem Multiplizierer 60 mit dem Block $W_2$ von Koeffizienten multipliziert, während zur Realisierung des Filters 42 in Fig. 3 dieselben Daten im Multiplizierer 70 mit dem Block $W_0$ von Koeffizienten multipliziert werden. Entsprechend werden die am Ausgang des Speichers 50 vorhandenen Daten für das Filter 24 im Multiplizierer 61 mit dem Block $W_3$ von Koeffizienten multipliziert, während für das Filter 42 diese Daten im Multiplizierer 71 mit dem Block $W_1$ von Koeffizienten multipliziert werden. Dies gilt entsprechend für folgende Speicher, bis zum drittletzten Speicher 52, dessen Daten im Multiplizierer 62 mit dem Block $W_{K-1}$ multipliziert werden und im Multiplizierer 72 mit dem Block $W_{K-3}$ multipliziert werden. Da das Filter 42 die volle Länge von K Partitionen aufweist, während das Filter 24 nur (K-2) Partitionen hat, führen die letzten beiden Speicher 53 und 54 nur auf die Multiplizierer 73 und 74, wo sie mit den Blöcken $W_{K-2}$ bzw. $W_{K-1}$ von Koeffizienten multipliziert werden. Die Die erzeugten Produkte werden in den Summierern 65 bzw. 35 summiert und über den Ausgang 25 bzw. 43 abgegeben.

Die Ausgänge 25 und 43, die je einen Block von gefilterten Daten abgeben, führen nun auf getrennte Transformationsanordnungen 26 bzw. 46 zur Durchführung einer Transformation mit diesen Daten, die zur Transformation in der Transformationsanordnung 44 invers ist. Der Datenblock am Ausgang der Transformationseinheit 46 wird direkt zu der Überlagerungsanordnung 48 in Fig. 5 weitergeleitet, während die Ausgangsdaten der Transformationseinheit 26 über die Verzögerungsanordnung 27 zu einer Umwandlungsstufe 31 geführt wird, die die Daten in einen seriellen Strom überführt, der der Summieranordnung 28 in Fig. 5 zugeleitet wird.

Die Verarbeitungsvorgänge für einen Block von Daten in der Transformationsanordnung 44, den Multiplizierern 60 bis 62 bzw. 70 bis 74 und den Transformationsanordnungen 26 und 46 können innerhalb der Zeitspanne, in der ein Datenblock in der Anordnung 30 gesammelt wird, durchgeführt werden. Da die Anordnung 30 eine Verzögerung um einen Block bewirkt, gehören die am Ausgang der Anordnung 31 auftretenden Signale zu Empfangssignalen auf dem Empfangspfad 1, die um zwei Blöcke zurückliegen, d.h. die in Fig. 5 dargestellte Anordnung der Filter 24 und 42 hat eine Verzögerungszeit von zwei Blöcken. In diesem Falle entfällt die Verzögerungsanordnung 27, da die Verzögerung durch die beschriebene zeitliche Abfolge von Datensammlung (Blockbildung) und Datenverarbeitung erzielt wird. Damit braucht, wie bereits erwähnt, das Zeitbereichsfilter 20 in Fig. 5 nur eine Länge von zwei Blöcken zu haben.

**Patentansprüche**

1. Digitale Filteranordnung zum Erzeugen einer Folge von digitalen Filtersignalen aus einer Folge von einem Filtereingang zugeführten digitalen Eingangssignalen mit Hilfe einer Anzahl N Filterkoeffizienten,
   <u>dadurch gekennzeichnet,</u>
   daß das Filter (2) ein Zeitbereichsfilter (20) der Ordnung M1 zum Erzeugen erster Teilfiltersignale unter Verwendung der ersten M1 Koeffizienten und ein Frequenzbereichsfilter (24) der Ordnung M2 zum Erzeugen zweiter Teilfiltersignale unter Verwendung der folgenden M2 Koeffizienten umfaßt mit M1+M2=N, wobei die Summe des ersten und des zweiten Teilfiltersignals das Filtersignal darstellt.

2. Filteranordnung nach Anspruch 1,
   <u>dadurch gekennzeichnet,</u> daß das Frequenzbereichsfilter (24) aus (K-p) Partitionen für die blockweise Verarbeitung von je M Signalen aufgebaut ist, mit M=N/K, K=2,3,4... und p=1,2,...<K, wobei M1=M·p und M2=M(K-p) ist.

3. Filteranordnung nach Anspruch 2,
   <u>dadurch gekennzeichnet,</u>
   daß K≥4 und p=2 ist.

4. Schaltungsanordnung zur Echoauslöschung mit einem ersten Filter nach Anspruch 1, das zwischen einen Empfangspfad (1) für Empfangssignale und einem Eingang einer überlagerungsanordnung geschaltet ist, von der ein anderer Eingang zum Empfang eines durch Überlagerung eines örtlich erzeugten Signals und eines veränderten Empfangssignals gebildeten Signals eingerichtet ist und mit einer Rechenanordnung (4; 40) sowie eines zweiten Filters (42) zur wiederholten adaptiven Erzeugung von Koeffizienten für das erste Filter.

5. Schaltungsanordnung nach Anspruch 3, wobei das zweite Filter ein weiteres Frequenzbereichsfilter ist und dieses weitere Frequenzbereichsfilter sowie das Frequenzbereichsfilter des ersten Filters aus Partitionen für die blockweise Verarbeitung von je M Signalen aufgebaut ist,
   <u>dadurch gekennzeichnet,</u>
   daß die erste Partition eine beiden Frequenzbereichsfiltern gemeinsame Transformationsanordnung (44) zur Durchführung einer orthogonalen Transformation eines Blocks Eingangssignale und die folgenden Partitionen je eine beiden Frequenzbereichsfiltern gemeinsame Speicheranordnung (50, 52, 54) zum Speichern eines von der Transformationsanordnung (44) bzw. von der Speicheranordnung (50, 52) der vorhergehenden Partition abgegebenen Blocks transformierter Signale umfassen.

## Claims

1. A digital filter device for producing a sequence of digital filter signals from a sequence of digital input signals fed to a filter input, with the aid of a number N of filter coefficients, characterized in that the filter (2) comprises a time-domain filter of the order M1, for producing first filter element signals using the first M1 coefficients, and a frequency-domain filter (24) of the order M2, for producing second filter element signals using the following M2 coefficients, where M1+M2=N, where the sum of the first and second filter element signals represents the filter signal.

2. The filter device according to Claim 2,
characterized in that the frequency-domain filter (24) is formed by (K-p) partitions for block-by-block processing of M signals, where M=N/K, K=2,3,4... and p=1,2... <K, where M1=M.p and M2=M(K-p).

3. The filter device as claimed in Claim 2, characterized in that K≥4 and p=2.

4. A circuit arrangement for echo suppression having a first filter according to Claim 1 which is connected between a receiving path (1) for received signals and one input of a superposition arrangement, another input of which is set up for receiving a signal which is formed by superpositioning of a locally produced signal and a changed received signal, and having a computation arrangement (4; 40), and a second filter (42) for repeated adaptive production of coefficients for the first filter.

5. The circuit arrangement according to Claim 3, the second filter being a further frequency-domain filter, and this further frequency-domain filter together with the frequency-domain filter of the first filter being formed by partitions for block-by-block processing of M signals each, characterized in that the first partition comprises a transformation arrangement (44) which is common to both frequency-domain filters, for carrying out an orthogonal transformation of a block of input signals, and the following partitions comprise each one memory arrangement (50, 52, 54) which is common to both frequency-domain filters, for storing a block of transformed signals produced by the transformation arrangement (44) or by the memory arrangement (50, 52) of the preceding partition.

## Revendications

1. Dispositif de filtrage numérique en vue de la production d'une séquence de signaux de filtrage numériques à partir d'une séquence de signaux d'entrée numériques amenés à une entrée de filtrage à l'aide d'un nombre N de coefficients de filtrage, caractérisé en ce que le filtre (2) comprend un filtre de plage de temporisation (20) d'ordre M1 en vue de la production de premiers signaux de filtrage partiels en utilisant les M1 premiers coefficients et un filtre de plage de fréquences (24) d'ordre M2 en vue de la production de deuxièmes signaux de filtrage partiels en utilisant les M2 coefficients suivants avec M1+M2=N, la somme des premier et deuxième signaux de filtrage partiels représentant le signal de filtrage.

2. Dispositif de filtrage selon la revendication 1, caractérisé en ce que le filtre de plage de fréquences (24) se compose de (K-p) partitions pour le traitement par blocs de respectivement M signaux avec M=N/K, K=2, 3, 4... et p=1, 2, 3.. < K, où M1=M·p et M(K-p).

3. Dispositif de filtrage selon la revendication 2, caractérisé en ce que K≥4 et p=2.

4. Circuit en vue de l'effacement de l'écho avec un premier filtre selon la revendication 1, qui est monté entre une voie de réception (1) pour les signaux de réception et une entrée d'un dispositif de superposition à partir duquel une autre entrée est constituée en vue de la réception d'un signal formé par superposition d'un signal produit localement et d'un signal de réception modifié et avec un ordinateur (4; 40) ainsi qu'un deuxième filtre (42) en vue de la production adaptative répétée de coefficients pour le premier filtre.

5. Circuit selon la revendication 3, le deuxième filtre étant un autre filtre de plage de fréquences et cet autre filtre de plage de fréquences ainsi que le filtre de plage de fréquences du premier filtre se composant de partitions pour le traitement par blocs de respectivement M signaux, caractérisé en ce que la première partition comprend un dispositif de transformation (44) commun aux deux filtres de plage de fréquences en vue de l'exécution d'une transformation orthogonale d'un bloc de signaux d'entrée et les partitions suivantes respectivement un dispositif de mémoire commun aux deux filtres de plage de fréquences (50, 52, 54) en vue de l'enregistrement d'un bloc de signaux transformés délivrés par le dispositif de transformation (44) ou par le dispositif de mémoire (50, 52) de la partition précédente.

Fig.1

Fig.2

Fig.3

Fig.4

Fig.5

Fig.6